(19) Europäisches Patentamt

European Patent Office

Office européen des brevets

(11) **EP 0 949 306 B1**

(12) **EUROPÄISCHE PATENTSCHRIFT**

(45) Veröffentlichungstag und Bekanntmachung des Hinweises auf die Patenterteilung:
**12.11.2003  Patentblatt 2003/46**

(51) Int Cl.⁷: **C09D 5/24**, C09D 5/02, C09D 143/04

(21) Anmeldenummer: **99105935.3**

(22) Anmeldetag: **24.03.1999**

(54) **Beschichtungszusammensetzung zur Herstellung von elektrisch leitfähigen Schichten**

Coating composition for the production of electrically conductive layers

Composition de revêtement pour couche électroconductrice

(84) Benannte Vertragsstaaten:
**DE FR GB**

(30) Priorität: **06.04.1998  DE 19815291**

(43) Veröffentlichungstag der Anmeldung:
**13.10.1999   Patentblatt 1999/41**

(73) Patentinhaber: **Ferro GmbH**
**60327 Frankfurt (DE)**

(72) Erfinder:
• **Starz, Karl-Anton Dr.**
**63517 Rodenbach (DE)**
• **Peter, Willi**
**63825 Blankenbach (DE)**

(74) Vertreter: **Reinhardt, Markus, Dipl.-Ing.**
**Reinhardt Söllner Ganahl,**
**Patentanwälte,**
**P.O. Box 1226**
**85542 Kirchheim bei München (DE)**

(56) Entgegenhaltungen:
**EP-A- 0 835 913**

• **PATENT ABSTRACTS OF JAPAN vol. 012, no. 279 (C-517), 1. August 1988 (1988-08-01) & JP 63 057676 A (CHUGOKU TORYO KK;OTHERS: 01), 12. März 1988 (1988-03-12)**

**Beschreibung**

Die Erfindung betrifft Beschichtungszusammensetzungen zur Herstellung von elektrisch leitfähigen Schichten auf elektrisch nichtleitenden Substraten, wie etwa Glas, Keramik oder Kunststoff.

Derartige "leitfähige Lacke" werden zum Beispiel für Beschichtung zur elektromagnetischen Abschirmung (EMI-Abschirmung) von elektronischen Geräten wie Personalcomputern oder portablen Telefonen eingesetzt. Dazu bringt man die Lacke auf die entsprechenden Kunststoffgehäuse durch Sprühen oder Tauchen auf und trocknet anschließend an Luft oder im Ofen, um flüchtige Bestandteile zu entfernen. Weitere Anwendungen dieser Lacke sind die Herstellung von Leiterplatten und die Metallisierung von Wachskernen für den Galvanoformungs-Prozess.

Zusammensetzungen für diese Anwendungen enthalten üblicherweise feine metallische sowie gegebenenfalls auch nichtmetallische Pulver, die in einem Bindemittel-Lösungsmittelsystem dispergiert sind.

Konventionelle leitfähige Lacke enthalten meist einen großen Anteil an flüchtigen organischen Lösungsmitteln wie Ethylenglycol, Butylacetat, Ethylglycolacetat usw. Die verwendeten Lösungsmittel sind in der Regel gesundheitsschädlich und umweltschädlich. Die maximale Konzentration dieser Komponenten am Arbeitsplatz ist daher limitiert. Bei der Verarbeitung und Trocknung der Lacke sowie beim Reinigen der verwendeten Behälter und Gerätschaften sind deshalb besondere Arbeitsschutzvorrichtungen wie Abzüge, Absauganlagen, Filteranlagen oder Lösemittelrückgewinnungsanlagen zu installieren. Wenn es sich um leicht brennbare Lösemittel handelt, müssen darüberhinaus Vorrichtungen zum Explosionsschutz vorhanden sein.

In neuer Zeit ist man bestrebt, die organischen Lösemittel soweit als möglich durch Wasser zu ersetzten, um die Gesundheitsgefährdung der Mitarbeiter und die Umweltbelastung zu minimieren.

Die DE 44 31 723 C2 beschreibt Metallisierungspasten zum Beschichten von anorganischen Substraten durch Siebdruck aber auch durch Sprühen und Tauchen. Die hierbei eingesetzten wäßrigen Dispersionen werden mit rheologischen Hilfsstoffen hergestellt und enthalten kein organisches Bindemittel. Diese Zusammensetzungen zeigen daher beim Trocknen keine chemische Vernetzung. Dementsprechend weisen die erzeugten leitfähigen Schichten keine ausreichende Haftfestigkeit und Beständigkeit gegenüber Abrieb und Feuchte auf. Sie sind deshalb für Abschirmzwecke unbrauchbar.

Auch die US 5,492,653 beschreibt Beschichtungszusammensetzungen, die im Sprühverfahren verarbeitet werden können. Diese Lacke enthalten blättchenförmiges Silberpulver, das mit organischen Carbonsäuren beschichtet ist, und außerdem einen erheblichen Anteil (bis zu 8 Gew.%) an organischen Lösungsmitteln. Dabei kommen Lösemittel wie beispielsweise Diethylenglygolmonobutylether zum Einsatz, Materialien also, die toxisch nicht unbedenklich sind.

Es war daher die Aufgabe der vorliegenden Erfindung, eine Zusammensetzung zur Herstellung von leitfähigen Schichten bereitzustellen, die haftfeste, leitfähige Schichten liefert und deren Bindemittel-Lösungsmittelsystem praktisch vollständig auf wäßriger Basis aufgebaut ist. Insbesondere sollte der Anteil an organischen Lösungsmitteln kleiner als 0,5 Gew.% sein. Die Anwendung der Beschichtungszusammensetzung sollte durch Sprühen, Pinseln oder Tauchen erfolgen können.

Überraschend wurde nun gefunden, daß diese Anforderungen von einer Beschichtungszusammensetzung erfüllt werden, die in einem wäßrigen Lösungsmittel ein oder mehrere leitfähige Pigmente, ein organisches Bindemittel sowie gegebenenfalls Additive und Hilfsstoffe enthält, wobei das organische Bindemittel ein in Wasser dispergierbares Copolymer auf Basis von (Meth)Acrylat- und silylierten ungesättigten Monomeren ist und der Gesamtgehalt der Zusammensetzung an organischen Lösungsmitteln 0,5 Gew.% nicht übersteigt.

Gegenstand der Erfindung ist somit eine wie vorstehend charakterisierte Beschichtungszusammensetzung zur Herstellung elektrisch leitfähiger Schichten.

Es hat sich gezeigt, daß bei einem Einsatz von derartigen teilweise silylierten (Meth)Acrylat-Copolymeren als Bindemittel in leitfähigen Beschichtungszusammensetzungen mit ansonsten hierbei üblichen Bestandteilen, aber mit Wasser als Lösungsmittel, leitfähige Beschichtungen mit vorzüglicher Haftfestigkeit, mechanischer Resistenz und Beständigkeit gegenüber Lösungsmitteln erhalten werden können. Diese Eigenschaften dürften auf eine Vernetzung von Silanolgruppen zurückzuführen sein, die sich aus den im Copolymer enthaltenen Silylgruppen bilden. Durch die Bildung eines Polysiloxan-Netzwerkes zusätzlich zur Filmbildung, die durch Verfließen des in der Zusammensetzung dispergierten Polymerharzes bei der Trocknung bzw. Härtung stattfindet, erhält man sehr haftfeste und gegenüber Lösungsmitteln und mechanische Einwirkung resistente leitfähige Lackschichten.

Das erfindungsgemäß als Bindemittel einzusetzende silylierte Copolymer besteht aus einem Grundgerüst aus Acrylat- bzw. Methacrylat- und/oder vinylischen Monomereinheiten, die zum Teil Silylgruppen tragen. Eine geeignete Silylfunktionalisierung wird mit Trialkoxysilyl-Gruppen, wie insbesondere Trimethoxy- und Triethoxysilyl-Gruppen, bewirkt. Diese werden leicht durch Hydrolyse in Silanolgrupppen (-Si-OH) überführt, die sich zu einem Polysiloxan-Netzwerk (-O-Si-O-Si-O-) verbinden können.

Typische silylierte Comonomere sind beispielsweise Methacryloxypropyl-trimethoxysilan und Vinyltrimethoxysilan.

Das Copolymer weist zweckmäßigerweise einen Silylierungsgrad von 0,05 bis 50 % auf. Derartige Copolymere sind ohne weiteres in Wasser dispergierbar, wobei auf organische (Co)Solventien verzichtet werden kann.

Ein typisches Copolymer ist beispielsweise zusammengesetzt aus 45 % Methylmethacrylat, 50 % n-Butylacrylat und 5 % Methacryloxypropyltrimethoxysilan und besitzt einen Restmonomergehalt an den jeweiligen Monomeren von weniger als 0,05 Gew.%.

Zweckmäßigerweise wird das als Bindemittel fungierende Copolymer in der erfindungsgemäßen leitfähigen Beschichtungszusammensetzung in Form einer wäßrigen Dispersion eingesetzt. Eine solche Polymerdispersion hat einen Feststoffgehalt von 25 bis 50 Gew.%, vorzugsweise von 30 bis 40 Gew.%. Derartige Polymerdispersionen sind selbstvernetzend; ihre Mindestfilmbildungstemperatur (MFT) kann je nach Zusammensetzung beliebig eingestellt werden. Entsprechende Polymerdispersionen sind im Handel erhältlich (z.B. SD 194, Degussa AG; SANMOL SW 131, SW 135, Sanyo Chemicals). Der Einsatz dieser speziellen silylierten Acrylat-Copolymerdispersionen gewährleistet überraschenderweise auch ein besseres Absetzverhalten im Vergleich zu lösemittelhaltigen Produkten. Daraus resultiert eine einfachere Verarbeitung des Lackes beim Sprühen, Pinseln oder Tauchen.

Die erfindungsgemäßen Beschichtungszusammensetzungen enthalten leitfähige Pigmente sowie gegebenenfalls weitere Additive und/oder Hilfsstoffe.

Als leitfähige Pigmente kommen vorzugsweise blättchenförmige Silberpulver (z.B. F14, D21, D12 oder D35, Degussa AG) oder blättchenförmige Kupferpulver (z.B. Typ MP 6100, Eckart-Werke) zum Einsatz. Auch metallisierte anorganische blättchenförmige Pigmente (z.B. EMI-Pigment TP1029A, Cerdec AG) kann Verwendung finden. Daneben können auch Pulver von leitfähigen anorganischen Oxiden, wie beispielsweise fluoriddotiertes Zinnoxid $SnO_2(F)$ oder Indium/Zinnoxid $In_2O_3/SnO_2$ eingesetzt werden.

Als Lackadditive und Hilfsstoffe kommen vor allem Netzmittel, Entschäumer, Thixotropiermittel, Haftvermittler und Vernetzer zum Einsatz. Auch Kombinationen aus verschiedenen Entschäumer- und Netzmitteltypen können verwendet werden (z.B. Dehydran 1227, Dehydran 1293G, Dehydran 1513 oder Dehydran 1620, (Henkel KGaA, Düsseldorf). Beispiele für Thixotropiermittel sind pyrogene Kieselsäuren (Aerosil, Degussa AG).Beispiele für Haftvermittler und Vernetzer sind Epoxysilane (z.B. Silan A174, Fa. Union Carbide).

Typischerweise besitzt der erfindungsgemäße leitfähige Lack die folgende Zusammensetzung:

| | |
|---|---|
| 2,5 bis 10 Gew.% | silyliertes Copolymer |
| 25 bis 75 Gew.% | leitfähiges Pigment |
| 13 bis 72,5 Gew.% | Wasser |
| 0 bis 3 Gew.% | Lackadditive (Entschäumer, Netzmittel, Thixotropiermittel, Haftvermittler, Vernetzer) |
| 0 bis 0,5 Gew.% | organisches Lösemittel. |

Da das Copolymer in Form einer rein wäßrigen Dispersion bzw. nur Wasser als Lösungsmittel zum Einsatz gelangt, ist die Menge der flüchtigen organischen Lösemittel im erfindungsgemäßen Lack durch den Anteil der Lackadditive (Entschäumer, Netzmittel etc.) in der Rezeptur begrenzt. Bei Verwendung von Entschäumern mit geringem Lösemittelgehalt (kleiner 40 %) kann die Menge an organischem Lösemittel im leitfähigen Lack auf weniger als 0,5 Gew. %, bezogen auf die Gesamtrezeptur, eingestellt werden. Bei Verwendung von Entschäumern auf voll-wäßriger Basis (z.B. Dehydran 1620) erhält man ein komplett wäßriges Lacksystem ohne jeglichen Anteil an organischen Lösungsmitteln.

Bei der Verarbeitung solcher Produkte wird die Gesundheitsgefährdung der Mitarbeiter sowie die Belastung der Umwelt minimiert, da nur geringste Mengen an organischen Lösungsmitteln freigesetzt werden. Zur Verdünnung des erfindungsgemäßen Lackes kann Wasser verwendet werden. Rückstände des Lackes an fehlerhaft beschichteten Teilen können mit Wasser entfernt werden; die Werkzeuge zur Verarbeitung des Lackes sind mit Wasser reinigbar. Da das Polymerharz eine geringe Wassergefährdung aufweist, ist auch die Entsorgung der wäßrigen Reinigungslösungen unproblematisch.

Folgende Beispiele sollen die Eigenschaften des erfindungsgemäßen Lackes näher erläutern (alle Prozentangaben in Gew.%):

Beispiel 1:

Entsprechend der nachfolgend angegebenen Rezeptur werden die folgenden Bestandteile in einem Behälter gemischt und anschließend mit einem geeigneten Rührer dispergiert:

| 50,0 % | blättchenförmiges Silberpulver (D12, Degussa AG, Hanau) |
| 8,4 % | silyliertes Copolymer (Typ SW 135, Fa. Sanyo, Japan) |
| 1,2 % | Entschäumer (Dehydran 1227, Fa. Henkel KGaA) |
| 40.4 % | Wasser |
| 100,0 % | |

Dieser Lack wird auf die Innenseite eines Gehäuses eines Mobiltelefons gesprüht, wobei die Sprühzeit so gewählt wird, daß man eine Schichtdicke von 10 µm nach der Trocknung erzielt. Nach dem Trocknen bei 60°C erhält man wisch- und kratzfeste sowie feuchtbeständige Schichten. Die elektrische Leitfähigkeit der Schichten beträgt 45 mOhm/Square, bezogen auf eine Lackschichtdicke von 10 µm. Der Haftfestigkeitstest (Klebefilm-Test) wird bestanden. Die Menge flüchtiger organischer Lösemittel in diesem Lack beträgt weniger als 0,5 Gew.%, bezogen auf die Gesamtrezeptur.

Beispiel 2:

Die folgenden Lackbestandteile werden eingewogen und anschließend dispergiert:

| 50,0 % | blättchenförmiges Silberpulver (F14, Degussa AG, Hanau) |
| 7,4 % | silyliertes Copolymer (Typ SW 131, Fa. Sanyo, Japan) |
| 1,5 % | Entschäumer (Dehydran 1620, Fa. Henkel KGaA) |
| 0,5 % | pyrogene Kieselsäure (Aerosil 200, Degussa AG) |
| 40.4 % | Wasser |
| 100,0 % | |

Dieser Lack wird auf die Innenseite eines Computergehäuses (Laptop) gesprüht. Er zeigt im feuchten Zustand kein Ablaufen von den Seiten, insbesondere keine Nasen- und Tropfenbildung. Nach dem Trocknen bei Raumtemperatur oder 60°C erhält man wisch- und kratzfeste, feuchtigkeitsbeständige Schichten. Die elektrische Leitfähigkeit der Schichten beträgt 40 mOhm/Square bei einer Schichtdicke von 10 µm. Die EMI-Abschirmeigenschaften des Materials sind gut. Der Lack enthält keine flüchtigen organischen Lösemittel, die beim Trocknen frei werden, können da als Entschäumer ein vollwäßriges System verwendet wird.

| 50,0 % | blättchenförmiges Silberpulver (D12, Degussa AG, Hanau) |
| 8,4 % | silyliertes Copolymer (Typ SD 194, Degussa AG, Hanau) |
| 2,0 % | Entschäumer (Dehydran 1227, Fa. Henkel KGaA) |
| 0,8 % | Haftvermittler (Silan A174, Fa. Union Carbide) |
| 8,8 % | Wasser |
| 100,0 % | |

Dieser Lack wird auf Polyesterfolien des Typs MYLAR A (DuPont) gepinselt. Er zeigt kein Ablaufen von Substraten, die Konturenstabilität ist gut. Nach dem Trocknen bei 60°C erhält man leifähige, sowie wisch- und feuchtebeständige Leiterbahnen. Die Menge flüchtiger organischer Lösemittel in diesem Lack beträgt weniger als 0,5 Gew.%, bezogen auf die Gesamtrezeptur.

Beispiel 4

Die folgenden Komponenten werden eingewogen und dispergiert:

| 50,0 % | blättchenförmiges Kupferpulver (MP 6100, Fa. Eckart-Werke, Fürth) |
| 8,4 % | silyliertes Copolymer (Typ SANMOL SW 131, Fa. Sanyo, Japan) |
| 2,0 % | Entschäumer (Dehydran 1620, Fa. Henkel KGaA) |
| 39,6 % | Wasser |
| 100,0 % | |

Dieser Lack wird auf Polyesterfolien des Typs MYLAR L (DuPont) gepinselt. Er zeigt kein Ablaufen von Substraten, die Konturenstabilität ist gut. Nach dem Trocknen bei 60°C erhält man wisch- und kratzfeste, sowie feuchtebeständige Leiterbahnen. Der Lack enthält keine flüchtigen organischen Lösemittel, die beim Trocknen frei werden können, da ein vollwäßriges Entschäumersystem zum Einsatz kommt.

Beispiel 5

Die folgenden Komponenten werden eingewogen und dispergiert:

| | |
|---|---|
| 50,0 % | Eisenoxid, versilbert (EMI-Pigment TP 1029A, Cerdec AG) |
| 8,4 % | silyliertes Copolymer (Typ SANMOL SW 131) |
| 1,2 % | Entschäumer (Dehydran 1227, Fa. Henkel KGaA) |
| 39,6 % | Wasser |
| 100,0 % | |

Der Lack wird auf ein Keramiksubstrat gesprüht. Nach dem Trocknen bei 60°C erhält man wisch- und kratzfeste, sowie feuchtebeständige Schichten. Die elektrische Leitfähigkeit der Schichten ist gut. Der Anteil flüchtiger organischer Lösemittel, die beim Trocknen frei werden, beträgt weniger als 0,5 %.

Beispiel 6

Die folgenden Komponenten werden eingewogen und dispergiert:

| | |
|---|---|
| 25,0 % | leitfähiges Zinnoxid $SnO_2(F)$ (Fa. Goldschmidt, Essen) |
| 10,0 % | silylierter Copolymer (SANMOL SW 130) |
| 1,2 % | Entschäumer (Dehydran 1620, Fa. Henkel KGaA) |
| 63,8 % | Wasser |
| 100,0 % | |

Der Lack wird auf Keramikplatten gesprüht und liefert nach dem Trocknen bei Raumtemperatur gut leitfähige Schichten. Der organische Lösemittelanteil beträgt 0%.

**Patentansprüche**

1. Beschichtungszusammensetzung zur Herstellung elektrisch leitfähiger Schichten, enthaltend in einem wäßrigen Lösungsmittel ein oder mehrere elektrisch leitfähige Pigmente, ein organisches Bindemittel sowie gegebenenfalls Additive und Hilfsstoffe,
   **dadurch gekennzeichnet,**
   **daß** sie als organisches Bindemittel ein in Wasser dispergierbares Copolymer auf Basis von (Meth)Acrylat und silylierten ungesättigten Monomeren enthält und daß der Gesamtgehalt der Zusammensetzung an organischen Lösungsmitteln 0,5 Gew.% nicht übersteigt.

2. Beschichtungszusammensetzung nach Anspruch 1,
   **dadurch gekennzeichnet,**
   **daß** das Copolymer einen Silylierungsgrad von 0,05 bis 50 % aufweist.

3. Beschichtungszusammensetzung nach Anspruch 1 oder 2,
   **dadurch gekennzeichnet,**
   **daß** sie eine wäßrige Dispersion des Copolymeres mit einem Feststoffgehalt von 25 bis 50 Gew.% , vorzugsweise 30 bis 40 Gew.%, enthält.

4. Beschichtungszusammensetzung nach den Ansprüchen 1 bis 3,
   **dadurch gekennzeichnet,**
   **daß** sie als elektrisch leitfähige Pigmente blättchenförmige Silberpulver, Kupferpulver, metallisierte blättchenförmige Pigmente oder leitfähige anorganische Pigmente enthält.

**5.** Beschichtungszusammensetzung nach den Ansprüchen 1 bis 4,
enthaltend

2,5 bis 10 Gew.% silyliertes Copolymer
25 bis 75 Gew.% elektrisch leitfähiges Pigment
13 bis 72,5 Gew.% Wasser
0 bis 3 Gew.% Additive und/oder Hilfsstoffe
0 bis 0,5 Gew.% organische Lösungsmittel.

**6.** Verwendung der Beschichtungszusammensetzungen gemäß den Ansprüchen 1 bis 5 zur Erzeugung von elektrisch
leitfähigen Schichten auf elektrisch nichtleitenden Substraten.

**7.** Verwendung der Beschichtungszusammensetzungen gemäß den Ansprüchen 1 bis 5 zur Metallisierung von nichtmetallischen Substraten.

**8.** Verwendung der Beschichtungszusammensetzungen gemäß den Ansprüchen 1 bis 5 zur Erzeugung von Schichten zur elektromagnetischen Abschirmung.

**9.** Verfahren zur Herstellung elektrisch leitfähiger Schichten auf elektrisch nichtleitenden Substraten,
**dadurch gekennzeichnet,**
**daß** man die Substrate mit einer Zusammensetzung gemäß den Ansprüchen 1 bis 5 beschichtet und anschließend
bei einer Temperatur zwischen 20 und 150°C trocknet.

**Claims**

**1.** A coating composition for producing electrically conductive layers, containing in an aqueous solvent one or more
electrically conductive pigments, an organic binding agent and also, optionally, additives and auxiliary substances,
**characterised in that**
by way of organic binding agent it contains a copolymer capable of being dispersed in water and based on (meth)
acrylate monomers and silylated unsaturated monomers and **in that** the total content of organic solvents in the
composition does not exceed 0.5 wt.%.

**2.** Coating composition according to Claim 1,
**characterised in that**
the copolymer has a degree of silylation from 0.05 % to 50 %.

**3.** Coating composition according to Claim 1 or 2,
**characterised in that**
it contains an aqueous dispersion of the copolymer with a solids content from 25 wt.% to 50 wt.%, preferably 30
wt.% to 40 wt.%.

**4.** Coating composition according to Claims 1 to 3,
**characterised in that**
by way of electrically conductive pigments it contains lamelliform silver powders, copper powders, metallised lamelliform pigments or conductive inorganic pigments.

**5.** Coating composition according to Claims 1 to 4, containing

2.5 wt.% to 10 wt.% silylated copolymer
25 wt.% to 75 wt.% electrically conductive pigment
13 wt.% to 72.5 wt.% water
0 wt.% to 3 wt.% additives and/or auxiliary substances
0 wt.% to 0.5 wt.% organic solvents.

**6.** Use of the coating compositions according to Claims 1 to 5 for generating electrically conductive layers on electrically non-conducting substrates.

**7.** Use of the coating compositions according to Claims 1 to 5 for metallising non-metallic substrates.

**8.** Use of the coating compositions according to Claims 1 to 5 for generating layers for the purpose of electromagnetic shielding.

**9.** A process for producing electrically conductive layers on electrically non-conducting substrates,
**characterised in that**
the substrates are coated with a composition according to Claims 1 to 5 and are subsequently dried at a temperature between 20 °C and 150 °C.

**Revendications**

**1.** Composition de revêtement pour la fabrication de couches électroconductrices, comprenant en milieu solvant aqueux un ou plusieurs pigments électroconducteurs, un liant organique ainsi que, le cas échéant, des additifs et des adjuvants,
**caractérisée en ce qu'**elle contient en tant que liant organique un copolymère que l'on peut disperser dans l'eau, à base de monomères insaturés de méthacrylate de méthyle et silylés, et que la teneur totale de la composition en solvant organique ne dépasse pas 0,5 % en poids.

**2.** Composition de revêtement selon la revendication 1,
**caractérisée en ce que**
le copolymère comporte un degré de silylation de 0,05 % à 50 %.

**3.** Composition de revêtement selon la revendication 1 ou 2,
**caractérisée en ce qu'**
elle contient une dispersion aqueuse de copolymère avec une teneur en matière solide de 25 % à 50 % en poids, de préférence 30 % à 40 % en poids.

**4.** Composition de revêtement selon les revendications 1 à 3,
**caractérisée en ce qu'**
elle contient en tant que pigments électroconducteurs de la poudre d'argent sous forme lamellaire, de la poudre de cuivre, des pigments lamellaires métallisés ou des pigments inorganiques conducteurs.

**5.** Composition de revêtement selon l'une des revendications 1 à 4, comprenant :

   2,5 % à 10 % en poids de copolymère silylé
   25 % à 75 % en poids de pigment électroconducteur
   13 % à 72,5 % en poids d'eau
   0 % à 3 % en poids d'additifs et/ou d'adjuvants
   0 % à 0,5 % en poids de solvant organique.

**6.** Utilisation de compositions de revêtement selon les revendications 1 à 5 pour la fabrication de couches électroconductrices sur des substrats électriquement non conducteurs.

**7.** Utilisation de compositions de revêtement selon les revendications 1 à 5 pour la métallisation de substrats non métalliques.

**8.** Utilisation de compositions de revêtement selon les revendications 1 à 5 pour la fabrication de couches pour la protection électromagnétique.

**9.** Procédé de fabrication de couches électroconductrices sur des substrats électriquement non conducteurs,
**caractérisé en ce que**
les substrats sont recouverts avec une composition selon les revendications 1 à 5 et ensuite séchés à une température entre 20 °C et 150 °C.